# EUROPEAN PATENT APPLICATION

(11) **EP 4 414 786 A1**
(43) Date of publication of application: **14.08.2024**
(21) Application number: 22885417.0
(22) Date of filing: 02.09.2022
(51) Int. Cl.: G03F 7/004, H01L 21/027

(54) **COMPOUND, PATTERNED MATERIAL, SEMICONDUCTOR DEVICE, TERMINAL, AND PATTERNING METHOD**

(30) Priority: 31.10.2021 CN 202111281644
(71) Applicant: Huawei Technologies Co., Ltd., Shenzhen, Guangdong 518129 (CN)
(72) Inventor: ZHANG, Lei, Fuzhou, Fujian 350002 (CN); YI, Xiaofeng, Fuzhou, Fujian 350002 (CN); WANG, Di, Fuzhou, Fujian 350002 (CN); DING, Qingrong, Fuzhou, Fujian 350002 (CN); ZHANG, Yu, Shenzhen, Guangdong 518129 (CN)
(74) Representative: Epping - Hermann - Fischer
(86) International application number: PCT/CN2022/116901
(87) International publication number: WO 2023/071526

(57) **Abstract**

This application provides an organic mixed metal-oxygen cluster compound, and a chemical general formula thereof is as follows: (M1)ₐ(M2)_{b}(M3)_{c}O_{g}(L1)ₓ(L2)_{y}(L3)_{z}, where M1 is selected from at least one of Ti, Zr, and Hf; M2 is selected from at least one of Bi, Te, Sn, Pt, Ag, and Au; M3 is selected from one of Fe, Ni, Co, and Cu; L1, L2, and L3 are respectively selected from organic ligands that directly coordinate with a metal and include one of O, S, Se, N, and P that serves as a ligating atom; a, b, g, x, y, and z are all natural numbers greater than or equal to 1; and c is a natural number greater than or equal to 0. This application further provides a patterning material including the organic mixed metal-oxygen cluster compound, a semiconductor device including the patterning material, a terminal, and a substrate surface patterning method. According to the substrate surface patterning method in this application, a simple material is used, and a pattern with high resolution and low edge roughness can be implemented.

## Description

### CROSS-REFERENCE TO RELATED APPLICATIONS

This application claims priority to Chinese Patent Application No. 202111281644.9, filed with the China National Intellectual Property Administration on October 31, 2021 and entitled "COMPOUND, PATTERNING MATERIAL, SEMICONDUCTOR DEVICE, TERMINAL, AND PATTERNING METHOD", which is incorporated herein by reference in its entirety.

### TECHNICAL FIELD

This application relates to an organic mixed metal-oxygen cluster compound, a patterning material including the organic mixed metal-oxygen cluster compound, a semiconductor device in which the patterning material is used, a terminal, and a substrate surface patterning method.

### BACKGROUND

With rapid development of the integrated circuit industry, especially when computing power of a chip per unit area is improved, in other words, when a key size corresponding to the chip becomes smaller, development of a patterning technology is indispensable. A patterning process usually includes the following steps: using a given pattern as a template, and irradiating on a film layer coated on a surface of a substrate through the template, so that an irradiated structure having an irradiated region and an unirradiated region is formed at the film layer; selectively dissolving and cleaning the irradiated structure or an unirradiated structure, where a pattern formed by a residual material is the same as a pattern on the template, and the residual patterning material may have etching resistance in an etching step; and selectively protecting the substrate from being etched or being slowly etched, to form a graph to transfer to the substrate, and forming a pattern on the substrate like a silicon wafer, where the pattern is an initially selectively exposed pattern.

In an advanced process of implementing graphics by using rays of a short wavelength (lower than 15 nm), because light source transmission efficiency of a patterning technology is low, it is required that a patterning material has high sensitivity and exposure energy is usually within 30 mJ/cm². Currently, there are several patterning material systems, including an organic polymer material system, an organic silicon material system, and the like. The organic polymer material system is of a traditional patterning material. Before a short wavelength below 15 nm is applied, the organic polymer material system is used. However, when a wavelength of a patterning light source is reduced to below 15 nm, resolution of a formed pattern needs to be improved. The organic silicon material system has high resolution and a small molecular size. However, silicon has low sensitivity to a light source whose wavelength is below 15 nm and requires extremely high exposure energy.

### SUMMARY

A first aspect of embodiments of this application provides an organic mixed metal-oxygen cluster compound, and a chemical general formula thereof is as follows:

(M1)ₐ(M2)_{b}(M3)_{c}O_{g}(L1)ₓ(L2)_{y}(L3)_{z},

where
M1 is selected from at least one of Ti, Zr, and Hf;
M2 is selected from at least one of Bi, Te, Sn, Pt, Ag and Au;
M3 is selected from at least one of Fe, Ni, Co, and Cu;
L1, L2, and L3 are respectively selected from organic ligands that can coordinate with a metal and that include at least one of O, S, Se, N, and P that serves as a ligating atom; and
a, b, g, x, y, and z are all natural numbers greater than or equal to 1, and c is a natural number greater than or equal to 0.

In this application, under exposure of soft X-rays whose wavelengths range from 1 nm to 15 nm, the organic mixed metal-oxygen cluster compound has high sensitivity and can be finely adjusted. The organic mixed metal-oxygen cluster compound includes metals and organic ligands. Types and proportions of different metals may be adjusted and/or a photosensitive functional group may be introduced into the organic ligand, to enhance photosensitiveness of the patterning material, improve line edge roughness, and improve resolution to 10 nm to 40 nm.

In an implementation of this application, 2≤a+b+c≤60.

In an implementation of this application, g+x+y+z≤8(a+b+c).

The g+x+y+z≤8(a+b+c) is obtained based on an atomic coordination number.

In an implementation of this application, 5≥b/(a+c)≥0.1.

In an implementation of this application, a ratio of a to b to c is 5:9:1.

In an implementation of this application, M1 is Ti, M2 is Bi, and M3 is at least one of Co and Ni.

In an implementation of this application, at least one of L1, L2, and L3 includes a functional group, and the functional group is selected from at least one of carboxylic acid, alcohol, phenol, nitrile, alkyne, alcoholamine, pyridine, pyrazole, imidazole, piperazine, and pyrazine.

The functional group is introduced into the organic ligands L1, L2, and L3, to adjust a property like solubility of the organic mixed metal-oxygen cluster compound, thereby affecting a thickness, film layer roughness, resolution, film layer adhesion, and corrosion resistance of a film layer including the organic mixed metal-oxygen cluster compound. In an implementation of this application, at least one of L 1, L2, and L3 includes a radiation-sensitive functional group, and the radiation-sensitive functional group includes at least one of a double bond, a triple bond, and epoxy propane. The radiation-sensitive functional group may further enhance photosensitiveness of the organic mixed metal-oxygen cluster compound, improve line edge roughness, and improve resolution.

In an implementation of this application, one or more of L1 and L2 coexist in a same organic ligand.

In an implementation of this application, at least a part of metal ions in the organic mixed metal-oxygen cluster compound are replaced by a radiation-sensitive element; the radiation-sensitive element includes at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally included in the organic mixed metal-oxygen cluster compound.

The radiation-sensitive element replaces the metal element of the organic mixed metal-oxygen cluster compound, so that photosensitiveness of the organic mixed metal-oxygen cluster compound can be enhanced.

A second aspect of embodiments of this application provides a patterning material, including an organic mixed metal-oxygen cluster compound. A chemical general formula of the organic mixed metal-oxygen cluster compound is as follows: (M1)ₐ(M2)_{b}(M3)_{c}O_{g}(L1)ₓ(L2)_{y}(L3)_{z}, where
M1 is selected from at least one of Ti, Zr, and Hf;
M2 is selected from at least one of Bi, Te, Sn, Pt, Ag and Au;
M3 is selected from at least one of Fe, Ni, Co, and Cu;
L1, L2, and L3 are respectively selected from organic ligands that directly coordinate with a metal and that include at least one of O, S, Se, N, and P that serves as a ligating atom; and
a, b, g, x, y, and z are all natural numbers greater than or equal to 1, and c is a natural number greater than or equal to 0.

The organic mixed metal-oxygen cluster compound is used as a main material of a patterning material, so that the patterning material can meet high sensitivity, high etching resistance, high resolution, low degassing (which means that less gas is released in an exposure process), a small molecular size, and material performance that may be finely adjusted by using mixed metals.

In an implementation of this application, 2≤a+b+c≤60, g+x+y+z≤8(a+b+c), and 5≥b/(a+c)≥0.1.

In an implementation of this application, a ratio of a to b to c is 5:9:1, M1 is Ti, M2 is Bi, and M3 is at least one of Co and Ni.

In an implementation of this application, at least one of L 1, L2, and L3 includes a functional group, and the functional group is selected from at least one of carboxylic acid, alcohol, phenol, nitrile, alkyne, alcoholamine, pyridine, pyrazole, imidazole, piperazine, and pyrazine.

In an implementation of this application, at least one of L 1, L2, and L3 includes a radiation-sensitive functional group, and the radiation-sensitive functional group includes at least one of a double bond, a triple bond, and epoxy propane. In an implementation of this application, one or more of L1 and L2 coexist in a same organic ligand.

In an implementation of this application, at least a part of metal ions in the organic mixed metal-oxygen cluster compound are replaced by a radiation-sensitive element; the radiation-sensitive element includes at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally included in the organic mixed metal-oxygen cluster compound.

A third aspect of embodiments of this application provides a semiconductor device, including:
a substrate; and
a function layer, located on a surface of the substrate, where the function layer includes the patterning material according to the second aspect of embodiments of this application.

Resolution of a pattern of the function layer is high, and roughness of an edge of the pattern is low.

A fourth aspect of embodiments of this application provides a terminal, including a housing and a semiconductor device accommodated in the housing, where the semiconductor device includes the semiconductor device according to the third aspect of embodiments of this application.

A fifth aspect of embodiments of this application provides a substrate surface patterning method, including:
providing a substrate;
forming a patterning material layer on a surface of the substrate, where the patterning material layer includes an organic mixed metal-oxygen cluster compound, and a chemical general formula of the organic mixed metal-oxygen cluster compound is as follows: (M1)ₐ(M2)_{b}(M3)_{c}O_{g}(L1)ₓ(L2)_{y}(L3)_{z}, where M1 is selected from at least one of Ti, Zr, and Hf; M2 is selected from at least one of Bi, Te, Sn, Pt, Ag, and Au; M3 is selected from at least one of Fe, Ni, Co, and Cu; L1, L2, and L3 are respectively selected from organic ligands that directly coordinate with a metal and include at least one of O, S, Se, N, and P that serves as a ligating atom; a, b, g, x, y, and z are all natural numbers greater than or equal to 1; and c is a natural number greater than or equal to 0;
performing local exposure on the patterning material layer; and
removing a part of the patterning material layer by using a developing solution.

According to the substrate surface patterning method in this application, a patterned patterning material layer with high resolution and low edge roughness can be obtained, thereby facilitating processing performed by using the semiconductor device.

In an implementation of this application, in the chemical general formula of the organic mixed metal-oxygen cluster compound, 2≤a+b+c≤60, g+x+y+z≤8(a+b+c), and 5≥b/(a+c)≥0.1.

In an implementation of this application, in the chemical general formula of the organic mixed metal-oxygen cluster compound, at least one of L1, L2, and L3 includes a functional group, and the functional group is selected from at least one of carboxylic acid, alcohol, phenol, nitrile, alkyne, alcoholamine, pyridine, pyrazole, imidazole, piperazine, and pyrazine.

In an implementation of this application, at least one of L1, L2, and L3 includes a radiation-sensitive functional group, and the radiation-sensitive functional group includes at least one of a double bond, a triple bond, and epoxy propane. In an implementation of this application, at least a part of metal ions in the organic mixed metal-oxygen cluster compound are replaced by a radiation-sensitive element; the radiation-sensitive element includes at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally included in the organic mixed metal-oxygen cluster compound.

In an implementation of this application, in the chemical general formula of the organic mixed metal-oxygen cluster compound, a ratio of a to b to c is 5:9:1, M1 is Ti, M2 is Bi, and M3 is at least one of Co and Ni.

In an implementation of this application, in a step of performing local exposure on the patterning material layer, any single-wavelength ray or mixed-wavelength ray that is of soft X-rays and that is within a wavelength range of 1 nm to 15 nm is used; or an electron beam is used; or extreme ultraviolet radiation is used.

In an implementation of this application, a mask is used in a step of performing local exposure on the patterning material layer by using the soft X-rays, and soft X-rays carrying pattern information reach the patterning material layer through the mask, to locally expose the patterning material layer.

In an implementation of this application, the developing solution is at least one of isopropanol, N,N-dimethylformamide, 2-acetoxy-1-methoxypropane, ethyl lactate, and water.

In an implementation of this application, the substrate surface patterning method further includes: etching the substrate by using, as a protective layer, the patterning material film layer remaining on the substrate.

### BRIEF DESCRIPTION OF DRAWINGS

FIG. 1 is a schematic diagram of a patterning process;
FIG. 2 is a schematic diagram of a cross-sectional structure of a semiconductor device according to an embodiment of this application;
FIG. 3 is a schematic diagram of a structure of an organic mixed metal-oxygen cluster compound according to Embodiment 1 of this application;
FIG. 4 is an infrared spectrogram of an organic mixed metal-oxygen cluster compound according to Embodiment 1 of this application;
FIG. 5A and FIG. 5B are scanning electronic microscopy diagrams of an exposed and developed patterning material coating;
FIG. 6 is a schematic diagram of a structure of an organic mixed metal-oxygen cluster compound according to Embodiment 2 of this application;
FIG. 7 is an infrared spectrogram of an organic mixed metal-oxygen cluster compound according to Embodiment 1 of this application; and
FIG. 8A and FIG. 8B are scanning electronic microscopy diagrams of an exposed and developed patterning material coating.

### Description of reference numerals of main components

| | |
|---|---|
| Semiconductor device | 100 |
| Substrate | 10 |
| Patterning material film layer | 20 |
| Function layer | 30 |

### DESCRIPTION OF EMBODIMENTS

The following describes embodiments of this application with reference to the accompanying drawings in embodiments of this application.

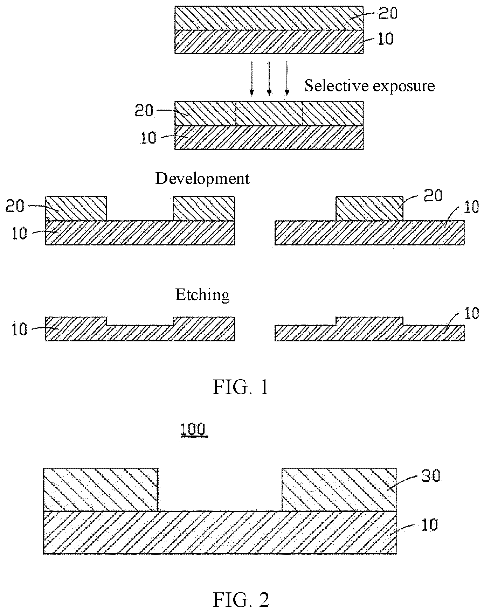

In a patterning process, a high-precision pattern may be formed by using an exposure light source with soft X-rays (Soft X-rays) whose wavelengths range from 1 nm to 15 nm or through electron beam etching. As shown in FIG. 1, a patterning process includes: (1) forming a patterning material film layer 20 on a substrate 10; (2) selectively exposing the patterning material film layer 20; (3) performing development on an exposed patterning material film layer 20 to remove a part of the patterning material film layer 20; and (4) etching the substrate 10 by using a remaining part of the patterning material film layer 20 as a protective layer.

The forming a patterning material film layer on a substrate in step (1) includes: mixing a patterning material with a proper solvent to form a solution of specific concentration, where the solution concentration may be adjusted according to a film thickness requirement, and generally, a higher solution concentration corresponds to a thicker film layer; taking, based on a size of the substrate, a solution of a specific volume to coat on the substrate in a manner of spin coating, where the substrate may be a silicon wafer; and forming, on a silicon wafer covered by another coating or on any other coating that uses a silicon wafer as a final substrate, a patterning material film layer whose thickness is less than 100 nm. Before selective exposure, a solvent left at the film layer is usually removed through baking.

In a selective exposure process in step (2), a mask (not shown in the figure) may be used. Any single-wavelength ray or mixed-wavelength ray in soft X-rays whose wavelengths range from 1 nm to 15 nm selectively irradiates on the patterning material film layer through the mask, to transfer a pattern on the mask to the patterning material film layer. After the patterning material is selectively irradiated, chemical properties and solubility of an irradiated part of the patterning material change.

In step (3), the irradiated patterning material is cleaned by using a developing solution (which may be selected from an organic solution, an inorganic solution, a pure solvent, a mixed solvent, a solvent including an additive, and the like). The cleaning lasts for 10s to 300s, and may be single-step cleaning or multi-step cleaning. When the patterning material is a positive patterning material, an irradiated part of the cleaned patterning material layer is cleaned off, to form a positive pattern. When the patterning material is a negative patterning material, the irradiated part of the cleaned patterning material layer is not cleaned off, to form a negative pattern.

In step (4), a pattern formed by the patterning material selectively protects the substrate in an etching step. After etching is performed under a specific condition, the patterning material and an unprotected part of the substrate are etched. However, an etching speed on a part that is of the substrate and that is protected by the patterning material is slower than that of the unprotected part, and finally, the pattern is formed on the substrate.

In the foregoing patterning process, soft X-rays whose wavelengths range from 1 nm to 15 nm or an electron beam without a mask is used for exposure. Under this condition, it is required that the obtained pattern has high resolution, low pattern edge roughness, and low consumed exposure energy. However, an existing patterning material cannot meet the requirements.

Therefore, this application provides a patterning material that can be used in a process of implementing patterning through exposure by using soft X-rays with a short wavelength (lower than 15 nm) or electron beams. The patterning material is highly sensitive to the soft X-rays with a short wavelength (lower than 15 nm), so that resolution of a pattern can be high, and edge roughness of the pattern is improved.

The patterning material includes an organic mixed metal-oxygen cluster compound. In addition to the organic mixed metal-oxygen cluster compound, the patterning material may further include an additive, for example, a stabilizer, a dispersant, or a solvent.

A chemical general formula of the organic mixed metal-oxygen cluster compound is as follows: (M1)ₐ(M2)_{b}(M3)_{c}O_{g}(L1)ₓ(L2)_{y}(L3)_{z}, where

M1 is selected from at least one of high-reactivity metals/high-resolution metals Ti, Zr, and Hf; M2 is selected from at least one of high-sensitivity metals Bi, Te, Sn, Pt, Ag, and Au; M3 is selected from at least one of bridge metals Fe, Ni, Co, and Cu; L1, L2, and L3 are respectively selected from organic ligands that directly coordinate with a metal and include but are not limited to O, S, Se, N, or P that serves as a ligating atom; a, b, g, x, y, and z are all natural numbers greater than or equal to 1; and c is a natural number greater than or equal to 0.

In some embodiments, when c=0, it indicates that the organic mixed metal-oxygen cluster compound includes only two metals: M1 and M2.

In some embodiments, 2≤a+b+c≤60.

In some embodiments, g+x+y+z≤8(a+b+c).The g+x+y+z≤8(a+b+c) is obtained based on an atomic coordination number.

In some embodiments, 5≥b/(a+c)≥0.1.

In an embodiment, a molar ratio of M1 to M2 to M3 is 5:9:1, that is, a ratio of a to b to c is 5:9:1. In addition, M1 is Ti, M2 is Bi, and M3 is at least one of Co and Ni.

In some embodiments, L1 and L2 may be organic ligands independent of each other. In some other embodiments, one or more (because there may be a plurality of organic ligands L1 and L2) of L1 and L2 coexist in a same organic ligand. For example, L1 and L2 coexist in a salicylic acid ligand. In this case, L1 may be an alcohol organic ligand, and L2 may be a carboxylic acid organic ligand.

In some embodiments, at least a part of metal ions in the organic mixed metal-oxygen cluster compound may be replaced by a radiation-sensitive element, to enhance photosensitiveness of the organic mixed metal-oxygen cluster compound. The radiation-sensitive element includes at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po. Because M1, M2, and M3 of the organic mixed metal-oxygen cluster compound may include at least one of the foregoing radiation sensitive elements Ti, Fe, Co, Ni, Cu, Ag, Sn, Te, Hf, Pt, Au and Bi, the radiation-sensitive element replacing the metal ions in the organic mixed metal-oxygen cluster compound is different from a metal element originally included in the organic mixed metal-oxygen cluster compound in this application. That is, for example, if the organic mixed metal-oxygen cluster compound includes a metal Ti, Ti is not selected as a radiation-sensitive element for replacement.

In some embodiments, a radiation-sensitive functional group may be introduced into at least one of L1, L2, and L3, to further enhance photosensitiveness of the organic mixed metal-oxygen cluster compound, improve line edge roughness, and improve resolution. The radiation-sensitive functional group includes at least one of a double bond, a triple bond, and epoxy propane.

In some embodiments, a radiation-sensitive functional group may be introduced into at least one of the organic ligands L1, L2, and L3. For example, the functional group may be at least one of additionally accessed groups such as carboxylic acid, alcohol, phenol, nitrile, alkyne, alcoholamine, pyridine, pyrazole, imidazole, piperazine, and pyrazine, to adjust a property like solubility of the organic mixed metal-oxygen cluster compound, thereby affecting a film layer thickness, film layer roughness, resolution, film layer adhesion, and corrosion resistance.

It may be understood that a ratio of ligating atoms of the organic ligand to metal ions may be adjusted, to improve sensitivity, line edge roughness, and resolution of the organic mixed metal-oxygen cluster compound.

In this application, the organic mixed metal-oxygen cluster compound includes metals and organic ligands. Types and proportions of different metals are adjusted and/or a photosensitive functional group may be introduced into the organic ligand, to further enhance photosensitiveness of the patterning material, improve line edge roughness, and improve resolution.

In this application, under exposure of soft X-rays whose wavelengths range from 1 nm to 15 nm, the organic mixed metal-oxygen cluster compound has high sensitivity and may be finely adjusted. The organic mixed metal-oxygen cluster compound is used as a main material of a patterning material, so that a problem that the patterning material needs to meet high sensitivity, high etching resistance, high resolution, low degassing (which means that less gas is released in an exposure process), a small molecular size, and material performance that may be finely adjusted by using mixed metals may be resolved.

In this application, the patterning method performed by using the foregoing patterning material includes the following steps.

### (a) Substrate surface processing

Hydrophilic processing: Cleaning is performed in a Piranha solution (H₂O:30% ammonia hydroxide:30% H₂O₂=5:1:1) for 15 min to 20 min, in deionized water, and then, in isopropanol. Before use, liquid on a surface of the substrate is dried by using an air gun.

Hydrophobic processing: After hydrophilic processing is performed on the substrate, hexamethyldisilazane (Hexamethyldisilazane, HMDS) is uniformly covered on the surface of the substrate in a manner of vapor plating or spin coating.

Anti-reflection layer processing: An anti-reflection layer is added at a bottom layer, or a silicon compound layer or a carbon compound layer is coated at the bottom layer in a manner of spin coating.

### (b) Solution preparation

The prepared organic mixed metal-oxygen cluster compound (white powder) is dissolved in a solvent to form a fining solution. If there is clear insolubility, a solvent is reselected, to dissolve the organic mixed metal-oxygen cluster compound to obtain a fining solution. Then, the solution is filtered to obtain a patterning material formula mixture. The solvent includes but is not limited to N,N-dimethylformamide, ethyl lactate, 2-acetoxy-1-methoxypropane, isopropanol, toluene, dichloromethane, and the like. A concentration of the organic mixed metal-oxygen cluster compound in the solvent is approximately 5 mg/mL to 30 mg/mL.

### (c) Film layer preparation

Based on the size of the substrate, a proper amount of the patterning material formula mixture is used for spin coating. For example, the patterned material formula mixture of 1 mL to 5 mL is usually spin-coated on a 4-inch silicon wafer, to obtain a patterning material film layer whose uniform thickness is between 5 nm and 200 nm and whose surface roughness is lower than 2 nm. After the spin coating, a baking step may be selectively added. A baking temperature ranges from 60°C to 200°C, and baking duration ranges from 20s to 120s to remove a residual solvent.

### (d) Film layer exposure

The patterning material film layer is selectively irradiated by an electron beam, extreme ultraviolet radiation, or soft X-rays whose wavelengths range from 1 nm to 15 nm. A chemical reaction occurs in an irradiated part of the patterning material film layer, and solubility of the irradiated part changes. In a step of performing local exposure on the patterning material layer by using soft X-rays, a mask is used. Soft X-rays carrying pattern information reach the patterning material layer through the mask, to locally expose the patterning material layer.

After the exposure, a baking step may be selectively added, to promote an unfinished chemical reaction at the film layer. A baking temperature ranges from 60°C to 200°C, and baking duration ranges from 20s to 120s.

### (e) Development process

In the development process, a developing solution is used to contact an exposed film layer, to dissolve and remove a part of the patterning material film layer. For example, the film layer may be immersed in the developing solution. Duration of contact between the developing solution and the film layer generally does not exceed 10 minutes.

In some embodiments, the developing solution includes solvents such as isopropanol, N,N-dimethylformamide, 2-acetoxy-1-methoxypropane, ethyl lactate, and water, or a combination thereof, and another solvent that enables a material to have different dissolution rates before and after radiation.

In some embodiments, the developing solution may be a developing solution including one of the following solvents or a mixture of a plurality of the following solvents: a tetramethylammonium hydroxide (TMAH) aqueous solution whose concentration ranges from 0.5% to 5%; an organic solvent like ketone, for example, cyclohexanone and methyl-2-n-pentyl ketone; alcohol, for example, 3-methoxy-1-butanol, 3-methyl-3-methoxy-1-butanol, 1-methoxy-2-propanol, 1-ethoxy-2-propanol, and diacetone alcohol; ether, for example, propylene glycol monomethyl ether, 2-methoxyethanol, propylene glycol monoethyl ether, 2-ethoxyethanol, 1,2-dimethoxypropane, and diethylene glycol dimethyl ether; ester, for example, propylene glycol monomethyl ether acetate (PGMEA), propylene glycol monoethyl ether acetate, ethyl pyruvate, butyl acetate, methyl 3-ethoxypropionate, ethyl 3-ethoxypropionate, tert-butyl acetate, tert-butyl propionate, and propylene glycol mono-tert-butyl ether acetate; lactone, for example, gamma-butyrolactone; and a high boiling point alcohol solvent, for example, diethylene glycol, propylene glycol, glycerol, 1,4-butanediol, or 1,3-butanediol.

Development duration of contact between the developing solution and the exposed film layer ranges from 10s to 120s. After the development process, a water rinsing process may be selectively added, and rinsing duration ranges from 10s to 120s. After the rinsing process, a baking process may be selectively added. A baking temperature ranges from 60°C to 200°C, and baking duration ranges from 20s to 120s.

### (f) Pattern representation

An electron microscope or an atomic force microscope is used to observe and measure an obtained pattern. Resolution of the obtained pattern ranges from 3 nm to 100 nm, and edge roughness ranges from 2% to 30% of the resolution of the pattern.

### (g) Etching process (selective)

The substrate is etched by using the patterning material film layer as a protective layer, and the pattern may be transferred to the substrate under an etching condition like oxygen ions or in an ion implantation process.

It may be understood that step (a) is performed selectively. In some embodiments, step (a) may alternatively be omitted, or the hydrophilic processing or hydrophobic processing in step (a) is performed.

It may be understood that step (g) is performed selectively. In some embodiments, step (g) may alternatively be omitted. In this way, the patterning film layer without being etched may remain on the substrate as a function layer.

This application further provides an electronic device (not shown in the figure), including a semiconductor device. In some embodiments, the semiconductor device may be a part of an integrated circuit (not shown in the figure). As shown in FIG. 2, a semiconductor device 100 includes a substrate 10 and a patterned function layer 30 (for example, a dielectric material layer) formed on the substrate 10. The function layer 30 includes the organic mixed metal-oxygen cluster compound. Resolution of a pattern of the function layer 30 is high and reach 10 nm to 40 nm. Edge roughness the pattern is low and is within 10% of the resolution.

The following further describes technical solutions in embodiments of this application by using specific embodiments.

### Embodiment 1

An organic mixed metal-oxygen cluster compound is synthesized: Ti₅CoBi₉O₉(C₇H₄O₃)₉(C₂OO)(C₇H₄O₃)₈. Specifically, the foregoing molecular formula may be expressed as [Ti(C₇H₄O₃)₃@Ti₂Co^{II}Bi₉O₈(µ₂-O)(µ₂-C₂OO)(C₇H₄O₃)₈, where @ indicates that [Ti(C₇H₄O₃)₃]₃ is connected to two Ti atoms in a center, one O atom is connected to two atoms in a µ2 bridging manner, and a (C₂OO) group is connected to two atoms in a µ2 bridging manner.

Bismuth salicylic acid of 0.05 mmol, cobalt acetate of 0.1 mol, salicylic acid of 0.1 mmol, and titanium tetraisopropanolate of 0.5 ml are mixed with acetonitrile of 8 mL, are heated to 80°C, and are cooled to a room temperature after three days. A precipitated crystal is the organic mixed metal-oxygen cluster compound.

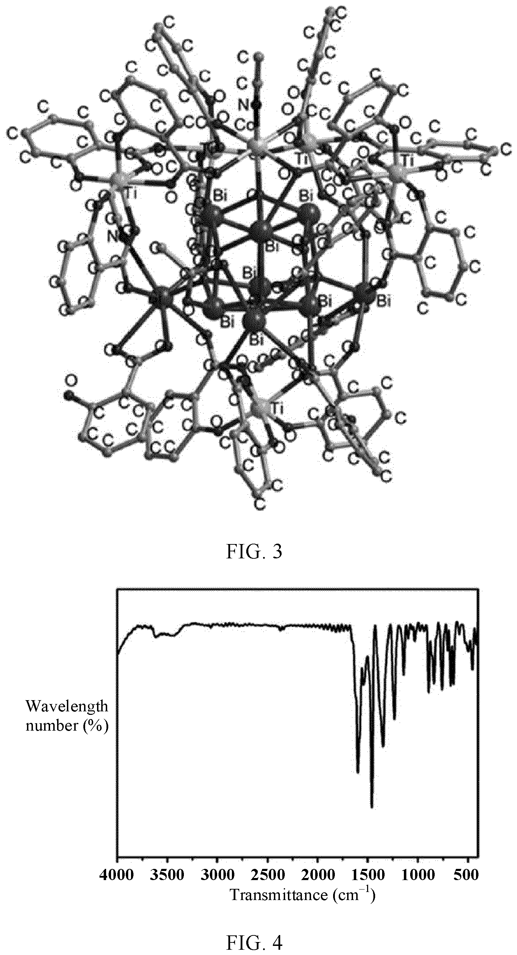

A schematic diagram of a structure of [Ti(C₇H₄O₃)₃]₃@Ti₂Co^{II}Bi₉O₈(µ₂-O)(µ₂-C₂OO)(C₇H₄O₃)₈ is shown in FIG. 3. For a clearer structure, some atoms such as oxygen, carbon, nitrogen, and hydrogen in FIG. 3 are omitted.

An infrared spectrogram of the organic mixed metal-oxygen cluster compound is shown in FIG. 4. A characteristic peak located at a position of 400 to 892 cm⁻¹ is an expansion vibration region of a metal oxygen bond, and indicates existence of Bi-O, Ti-O, and Co-O. A characteristic peak located at a position of 1032 to 1242 cm⁻¹ is an expansion vibration region of C-O. A characteristic peak located at a position of 1349 to 1595 cm⁻¹ shows skeleton vibration of a benzene ring, and indicates existence of the benzene ring. A characteristic peak located at a position of 3000 to 3500 cm⁻¹ is an expansion vibration region of O-H/N-H, is an H₂O peak, and indicates that the organic mixed metal-oxygen cluster compound includes trace water molecules.

### Patterning processing

Hydrophilic processing: Cleaning is performed in a Piranha solution (H₂O:30% ammonia hydroxide:30% H₂O₂=5:1:1) for 15 min to 20 min, in deionized water, and then, in isopropanol. Before use, liquid on a surface is dried by using an air gun. Hydrophobic processing: After hydrophilic processing is performed on the silicon wafer, HMDS is uniformly covered on the surface of the silicon wafer in a manner of vapor plating or spin coating.

Film layer preparation: The organic mixed metal-oxygen cluster compound of 5 mg to 20 mg is dissolved into N,N-dimethylformamide (DMF) of 1 mL, a solution is filtered, a proper amount of a filtered solution is taken and spin-coated on the surface of the hydrophilic or hydrophobic silicon wafer, to form a metal organic cluster patterning material coating.

Radiation exposure: Exposure is performed on the patterning material coating by using an electron beam etching technology (EBL).

Development: A developing solution combination for use includes a mixture (with a volume ratio ranging from 10: 1 to 1:10) of DMF and propylene glycol monomethyl ether acetate (PGMEA) and a mixture (with a volume ratio ranging from 10:1 to 1:10) of isopropanol (IPA) and PGMEA. Development duration ranges from 15s to 60s.

Graphic representation: A scanning electron microscope (SEM) is used to perform pattern representation on the exposed and developed patterning material coating.

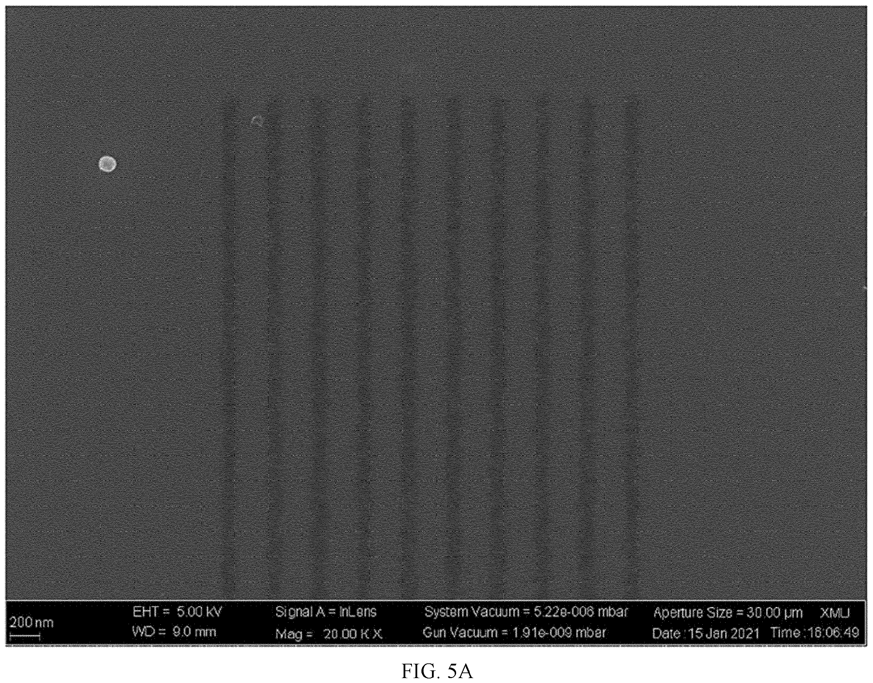

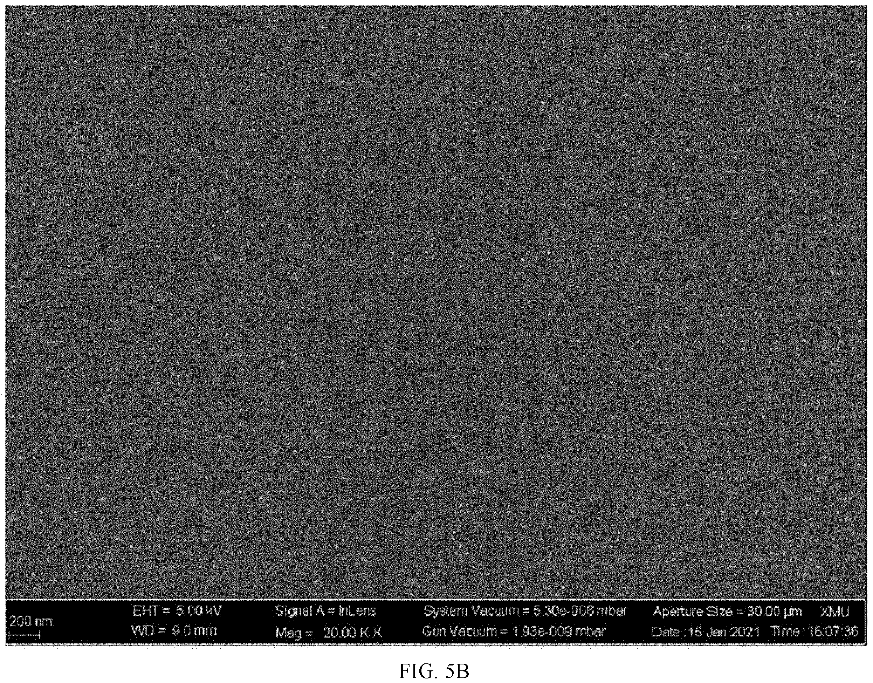

As shown in FIG. 5A and FIG. 5B, the exposed and developed patterning material coating is a plurality of lines extending in a same direction. A width of the lines in FIG. 5Ais 100 nm, and a width of the lines in FIG. 5B is 50 nm. Resolution of the exposed and developed patterning material coating may reach 100 nm or even 50 nm.

In this embodiment, a new-type Ti, Co, and Bi mixed metal-oxygen cluster compound may be used as a high-performance patterning material for exposure by using a light source whose wavelength is below 15 nm and an electron beam. A high-resolution pattern may be formed after the exposure. In addition, performance of the patterning material may be finely adjusted through a proportion of mixed metals.

### Embodiment 2

**An organic mixed metal-oxygen cluster compound is synthesized:** Ti₅NiBi₉O₉(C₇H₄O₃)₉(C₂OO)(C₇H₄O₃)₈. Specifically, the foregoing molecular formula may be expressed as [Ti(C₇H₄O₃)₃@Ti₂Ni^{II}Bi₉O₈(µ₂-O)(µ₂-C₂OO)(C₇H₄O₃)₈, where @ indicates that [Ti(C₇H₄O₃)₃]₃ is connected to two Ti atoms in a center, one O atom is connected to two atoms in a µ2 bridging manner, and a (C₂OO) group is connected to two atoms in a µ2 bridging manner.

Bismuth salicylic acid of 0.05 mmol, nickelous acetate of 0.1 mol, salicylic acid of 0.1 mmol, and titanium tetraisopropanolate of 0.5 ml are mixed with acetonitrile of 8 mL, are heated to 80°C, and are cooled to a room temperature after three days. A precipitated crystal is the organic mixed metal-oxygen cluster compound.

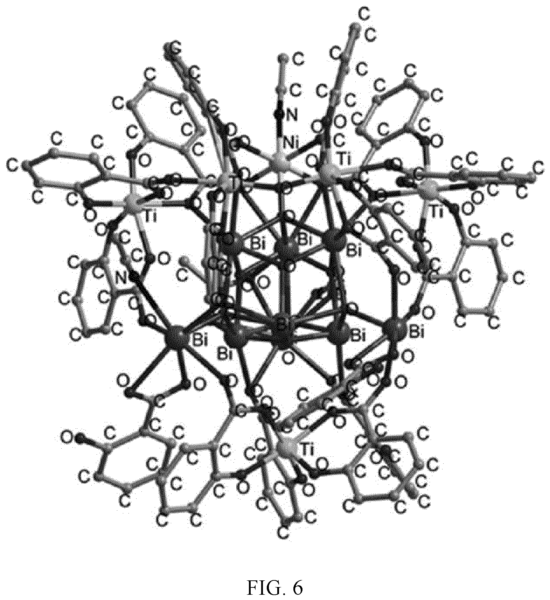

A schematic diagram of a structure of [Ti(C₇H₄O₃)₃@Ti₂Ni^{II}Bi₉O₈(µ₂-O)(µ₂-C₂OO)(C₇H₄O₃)₈ is shown in FIG. 6. For a clearer structure, some atoms such as oxygen, carbon, nitrogen, and hydrogen in FIG. 6 are omitted.

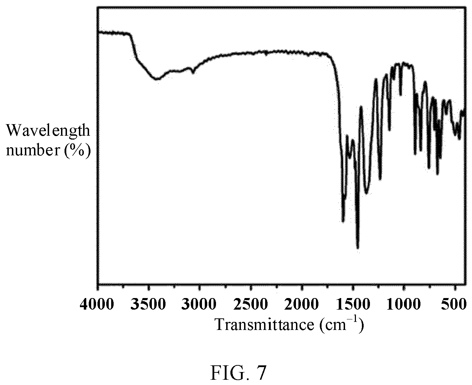

An infrared spectrogram of the organic mixed metal-oxygen cluster compound is shown in FIG. 7. A characteristic peak located at a position of 400 to 892 cm⁻¹ is an expansion vibration region of a metal oxygen bond, and indicates existence of Bi-O, Ti-O, and Ni-O. A characteristic peak located at a position of 1030 to 1240 cm⁻¹ is an expansion vibration region of C-O. A characteristic peak located at a position of 1464 to 1608 cm⁻¹ shows skeleton vibration of a benzene ring, and indicates existence of the benzene ring.

### Patterning processing

Silicon wafer processing: Hydrophilic processing: Cleaning is performed in a Piranha solution (H₂O:30% ammonium hydroxide:30% H₂O₂=5:1:1) for 15 min to 20 min, in deionized water, and then, in isopropanol. Before use, liquid on a surface of the silicon wafer is dried by using an air gun.

Hydrophobic processing: After hydrophilic processing is performed on the silicon wafer, HMDS is uniformly covered on the surface of the silicon wafer in a manner of vapor plating or spin coating.

Film layer preparation: A solid sample of 5 mg to 30 mg is dissolved into an ethyl lactate solvent of 1 mL, a solution is filtered, a proper amount of a filtered solution is taken and spin-coated on the surface of the hydrophilic or hydrophobic silicon substrate, to form a mixed metal organic cluster patterning material coating.

Radiation exposure: Exposure is performed on the patterning material layer by using an electron beam etching technology (EBL) in the present invention.

Development: A developing solution combination used in the present invention includes isopropanol. Development duration ranges from 15s to 60s.

Pattern representation: A scanning electron microscope (SEM) is used to perform pattern representation on the exposed and developed layer material.

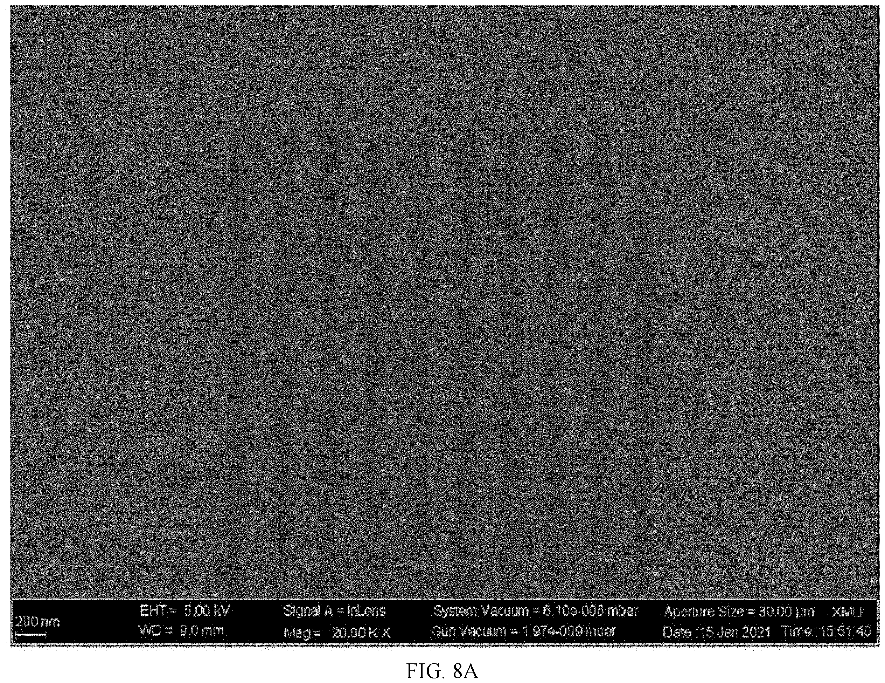

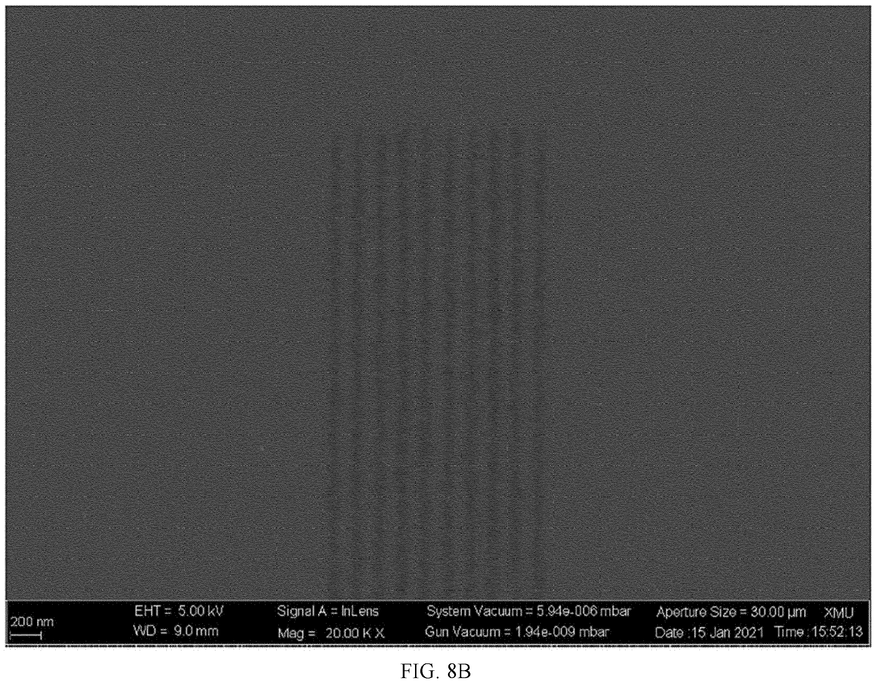

As shown in FIG. 8A and FIG. 8B, the exposed and developed patterning material coating is a plurality of lines extending in a same direction. A width of the lines in FIG. 8A is 100 nm, and a width of the lines in FIG. 8B is 50 nm. Resolution of the exposed and developed patterning material coating may reach 100 nm or even 50 nm.

It should be noted that the foregoing are merely specific implementations of this application, but the protection scope of this application is not limited thereto. Any change or replacement readily figured out by a person skilled in the art within the technical scope disclosed in this application shall fall within the protection scope of this application. In a case of no conflict, the implementations of this application and the features in the implementations may be mutually combined. Therefore, the protection scope of this application shall be subject to the protection scope of the claims.

## Claims

1. An organic mixed metal-oxygen cluster compound, wherein a chemical general formula thereof is as follows:
(M1)ₐ(M2)_{b}(M3)_{c}O_{g}(L1)ₓ(L2)_{y}(L3)_{z},
wherein
M1 is selected from at least one of Ti, Zr, and Hf;
M2 is selected from at least one of Bi, Te, Sn, Pt, Ag and Au;
M3 is selected from at least one of Fe, Ni, Co, and Cu;
L1, L2, and L3 are respectively selected from organic ligands that can coordinate with a metal and that comprise at least one of O, S, Se, N, and P that serves as a ligating atom; and
a, b, g, x, y, and z are all natural numbers greater than or equal to 1, and c is a natural number greater than or equal to 0.

2. The organic mixed metal-oxygen cluster compound according to claim 1, wherein 2≤a+b+c≤60.

3. The organic mixed metal-oxygen cluster compound according to claim 1 or 2, wherein g+x+y+z≤8(a+b+c).

4. The organic mixed metal-oxygen cluster compound according to any one of claims 1 to 3, wherein 5≥b/(a+c)≥0.1.

5. The organic mixed metal-oxygen cluster compound according to any one of claims 1 to 4, wherein a ratio of a to b to c is 5:9:1.

6. The organic mixed metal-oxygen cluster compound according to claim 5, wherein M1 is Ti, M2 is Bi, and M3 is at least one of Co and Ni.

7. The organic mixed metal-oxygen cluster compound according to any one of claims 1 to 6, wherein at least one of L1, L2, and L3 comprises a functional group, and the functional group is selected from at least one of carboxylic acid, alcohol, phenol, nitrile, alkyne, alcoholamine, pyridine, pyrazole, imidazole, piperazine, and pyrazine.

8. The organic mixed metal-oxygen cluster compound according to any one of claims 1 to 7, wherein at least one of L1, L2, and L3 comprises a radiation-sensitive functional group, and the radiation-sensitive functional group comprises at least one of a double bond, a triple bond, and epoxy propane.

9. The organic mixed metal-oxygen cluster compound according to any one of claims 1 to 8, wherein one or more of L1 and L2 coexist in a same organic ligand.

10. The organic mixed metal-oxygen cluster compound according to any one of claims 1 to 9, wherein at least a part of metal ions in the organic mixed metal-oxygen cluster compound are replaced by a radiation-sensitive element; the radiation-sensitive element comprises at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally comprised in the organic mixed metal-oxygen cluster compound.

11. A patterning material, comprising an organic mixed metal-oxygen cluster compound, wherein a chemical general formula of the organic mixed metal-oxygen cluster compound is as follows: (M1)ₐ(M2)_{b}(M3)_{c}O_{g}(L1)ₓ(L2)_{y}(L3)_{z}, wherein
M1 is selected from at least one of Ti, Zr, and Hf;
M2 is selected from at least one of Bi, Te, Sn, Pt, Ag and Au;
M3 is selected from at least one of Fe, Ni, Co, and Cu;
L1, L2, and L3 are respectively selected from organic ligands that directly coordinate with a metal and that comprise at least one of O, S, Se, N, and P that serves as a ligating atom; and
b; b, g, x, y, and z are all natural numbers greater than or equal to 1, and c is a natural number greater than or equal to 0.

12. The patterning material according to claim 11, wherein 2≤a+b+c≤60, g+x+y+z≤8(a+b+c), and 5≥b/(a+c)≥0.1.

13. The patterning material according to claim 11 or 12, wherein a ratio of a to b to c is 5:9: 1, M1 is Ti, M2 is Bi, and M3 is at least one of Co and Ni.

14. The patterning material according to any one of claims 11 to 13, wherein at least one of L1, L2, and L3 comprises a functional group, and the functional group is selected from at least one of carboxylic acid, alcohol, phenol, nitrile, alkyne, alcoholamine, pyridine, pyrazole, imidazole, piperazine, and pyrazine.

15. The patterning material according to any one of claims 11 to 14, wherein at least one of L1, L2, and L3 comprises a radiation-sensitive functional group, and the radiation-sensitive functional group comprises at least one of a double bond, a triple bond, and epoxy propane.

16. The patterning material according to any one of claims 11 to 15, wherein one or more of L1 and L2 coexist in a same organic ligand.

17. The patterning material according to any one of claims 11 to 16, wherein at least a part of metal ions in the organic mixed metal-oxygen cluster compound are replaced by a radiation-sensitive element; the radiation-sensitive element comprises at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally comprised in the organic mixed metal-oxygen cluster compound.

18. A semiconductor device, comprising:
a substrate; and
a function layer, located on a surface of the substrate, wherein the function layer comprises the patterning material according to any one of claims 11 to 17.

19. A terminal, comprising a housing and a semiconductor device accommodated in the housing, wherein the semiconductor device comprises the semiconductor device according to claim 18.

20. A substrate surface patterning method, comprising:
providing a substrate;
forming a patterning material layer on a surface of the substrate, wherein the patterning material layer comprises an organic mixed metal-oxygen cluster compound, and a chemical general formula of the organic mixed metal-oxygen cluster compound is as follows: (M1)ₐ(M2)_{b}(M3)_{c}O_{g}(L1)ₓ(L2)_{y}(L3)_{z}, wherein M1 is selected from at least one of Ti, Zr, and Hf; M2 is selected from at least one of Bi, Te, Sn, Pt, Ag, and Au; M3 is selected from at least one of Fe, Ni, Co, and Cu; L1, L2, and L3 are respectively selected from organic ligands that directly coordinate with a metal and comprise at least one of O, S, Se, N, and P that serves as a ligating atom; a, b, g, x, y, and z are all natural numbers greater than or equal to 1; and c is a natural number greater than or equal to 0;
performing local exposure on the patterning material layer; and
removing a part of the patterning material layer by using a developing solution.

21. The substrate surface patterning method according to claim 20, wherein in the chemical general formula of the organic mixed metal-oxygen cluster compound, 2≤a+b+c≤60, g+x+y+z≤8(a+b+c), and 5≥b/(a+c)≥0.1.

22. The substrate surface patterning method according to claim 20 or 21, wherein in the chemical general formula of the organic mixed metal-oxygen cluster compound, at least one of L1, L2, and L3 comprises a functional group, and the functional group is selected from at least one of carboxylic acid, alcohol, phenol, nitrile, alkyne, alcoholamine, pyridine, pyrazole, imidazole, piperazine, and pyrazine.

23. The substrate surface patterning method according to any one of claims 20 to 22, wherein at least one of L1, L2, and L3 comprises a radiation-sensitive functional group, and the radiation-sensitive functional group comprises at least one of a double bond, a triple bond, and epoxy propane.

24. The substrate surface patterning method according to any one of claims 20 to 23, wherein at least a part of metal ions in the organic mixed metal-oxygen cluster compound are replaced by a radiation-sensitive element; the radiation-sensitive element comprises at least one of Na, Mg, Al, K, Ca, Sc, Ti, V, Cr, Mn, Fe, Co, Ni, Cu, Zn, Ga, Ge, As, Rb, Sr, Y, Ga, Nb, Mo, Tc, Ru, Rh, Pd, Ag, Cd, Sn, Sb, Te, Cs, Ba, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Pb, Bi, and Po; and the radiation-sensitive element for replacement is different from a metal element originally comprised in the organic mixed metal-oxygen cluster compound.

25. The substrate surface patterning method according to any one of claims 20 to 24, wherein in the chemical general formula of the organic mixed metal-oxygen cluster compound, a ratio of a to b to c is 5:9:1, M1 is Ti, M2 is Bi, and M3 is at least one of Co and Ni.

26. The substrate surface patterning method according to any one of claims 20 to 25, wherein in a step of performing local exposure on the patterning material layer, any single-wavelength ray or mixed-wavelength ray that is of soft X-rays and that is within a wavelength range of 1 nm to 15 nm is used; or electron beams are used; or extreme ultraviolet radiation is used.

27. The substrate surface patterning method according to claim 26, wherein in a step of performing local exposure on the patterning material layer by using the soft X-rays, a mask is used, and soft X-rays carrying pattern information reach the patterning material layer through the mask, to locally expose the patterning material layer.

28. The substrate surface patterning method according to any one of claims 20 to 27, wherein the developing solution is at least one of isopropanol, N,N-dimethylformamide, 2-acetoxy-1-methoxypropane, ethyl lactate, and water.

29. The substrate surface patterning method according to any one of claims 20 to 28, wherein the substrate surface patterning method further comprises: etching the substrate by using, as a protective layer, the patterning material film layer remaining on the substrate.
